# DEMANDE DE BREVET EUROPEEN

(11) **EP 1 431 844 A1**
(43) Date de publication de la demande: **23.06.2004**
(21) Numéro de dépôt: 02028462.6
(22) Date de dépôt: 19.12.2002
(51) Int. Cl.: G04B 17/06, G04D 3/00, G03F 7/00

(54) **Assemblage pour organe régulateur d'un mouvement d'horlogerie**

(71) Demandeur: SFT Services SA, 1950 Sion (CH)
(72) Inventeur: Glassey, Marc-André, 1967 Bramois (CH); Lorenz, Hubert, 1965 Savière (CH)
(74) Mandataire: Cronin, Brian Harold John

(57) **Abrégé**

Cette invention concerne un assemblage pour organe régulateur (200) d'un mouvement d'horlogerie comprenant un spiral (100) et une virole (102) fabriqués en une seule pièce, obtenable par photostructuration et électroformage.

La matière utilisée pour la fabrication des spiraux est un alliage Fe/Ni/Cr dans lequel peuvent être ajoutés d'autres composants qui présente les particularités de ne pas devoir subir notamment de traitement thermique, de présenter un coefficient de dilatation faible, un coefficient thermo-élastique (CTE) proche de zéro et de réagir faiblement au magnétisme.

Les organes régulateurs (200) obtenus sont fabriqués en une seule pièce selon le procédé susmentionné. Leurs sections (E) sont notamment parallélépipèdes, variables ou non, leur pas (F) est variable ou non. Leur spiral (100) est encore uni ou bidirectionnel.

Les spiraux obtenus ne présentent que de faibles perturbations dues aux points d'attache des spiraux (100) sur la virole (102) et aux effets Grossmann et Caspari.

## Description

La présente invention est relative au domaine de l'horlogerie, plus particulièrement aux composants de mouvements d'horlogerie comportant un spiral de balancier.

La précision d'une montre dépend de la qualité de ses composants notamment d'un organe régulateur dans lequel un spiral joue un rôle prépondérant. Ceci amène les fabricants à améliorer sans cesse les performances desdits composants et plus précisément celles des spiraux en leur apportant un soin tout particulier lors de leur fabrication, façonnage et mise en fonction.

L'organe régulateur des montres mécaniques se compose d'un volant d'inertie appelé balancier sur l'axe duquel est fixé un ressort en spirale, appelé spiral, dont la fixation d'une extrémité sur l'axe de balancier se fait par l'intermédiaire d'une virole notamment chassée sur ledit axe. L'extrémité opposée du spiral est quant à elle fixée par collage ou goupillée à un piton pour permettre sa fixation à un coq. Les éléments composant l'organe régulateur sont fabriqués séparément et doivent être assemblés et réglés avec minutie, ce qui demande de la main d'oeuvre qualifiée et provoque par conséquent des coûts importants.

Il est à noter que la matière utilisée pour la fabrication des spiraux est primordiale pour maintenir leur couple le plus constant possible et ceci quelles que soient l'élongation, la température et la variation du champ magnétique.

Par ailleurs, les moyens conventionnels de fabrication ne permettent pas la réalisation de spiraux basés sur des modèles mathématiques optimisant les dits spiraux ce qui prive l'industrie horlogère de maintes possibilités d'évolution des organes régulateurs.

Afin de fabriquer un spiral de balancier pour un mouvement d'horlogerie, il est connu d'utiliser un procédé dans lequel on utilise un fil ou une bande métallique enroulée en forme de spiral tel qu'illustré dans la publication EP 0 911 7070 A1. Ce procédé est utile pour la fabrication de spiraux, séparés notamment de la virole et du balancier, utilisant des méthodes de fabrication conventionnelles et dont le dimensionnement n'utilise pas des modèles mathématiques compliqués.

Le but de la présente invention est de proposer un assemblage pour organe régulateur d'un mouvement d'horlogerie dans lequel notamment le spiral et la virole sont monobloc.

Ce but est atteint par un assemblage pour organe régulateur d'un mouvement d'horlogerie comprenant un spiral et une virole, caractérisé en ce que le spiral et la virole sont fabriqués en une seule pièce, obtenable par photostructuration et électroformage.

Le procédé de fabrication utilisé pour un organe régulateur notamment monobloc pour mouvement d'horlogerie de la présente invention est connu sous l'appellation LIGA (Lithographie Galvanoformung Abformung).

L'originalité de l'emploi du procédé LIGA est de pouvoir réaliser des assemblages pour organes régulateurs de mouvement d'horlogerie intégrant des parties fixes et mobiles ceci par le biais de la méthode de la couche sacrifiée dont le principe repose sur l'attaque sélective d'une couche photosensible de noblesse chimique nettement inférieure à celle du substrat électroformé et de réaliser ainsi des composants d'une très grande précision en X et Y et avec une épaisseur allant jusqu'à 1 mm.

Il est possible d'appliquer ce procédé en plusieurs étapes pour obtenir un composant en plusieurs niveaux, chaque niveau étant construit sur le précédent tel que précisé dans le tableau suivant :

| **1) Préparation** | **2) Lithographie** | **3) Electroformage** |
|---|---|---|
| Dépôt d'un substrat | Recouvrement d'un masque résistant | Remplissage du moule avec métal |
| Dépôt d'une couche d'adhésion | Exposition aux rayons UV | Enlèvement du moule et obtention de la pièce |
| Dépôt d'une couche supérieure photosensible | Enlèvement du masque et obtention du moule | |

Il est à noter que la couche d'adhésion et la couche supérieure peuvent être unifiées.

A l'aide de ce procédé on peut produire des organes régulateurs notamment monoblocs pour mouvements d'horlogerie en grande quantité à partir d'une seule étape de lithographie, ce qui a un effet positif sur les coûts et qui, comparé à l'usinage conventionnel, permet d'obtenir des spiraux de balancier de formes optimales calculées selon des modèles mathématiques compliqués. Des centaines, voire des milliers, de spiraux de balancier de formes optimales et de grande précision sont fabriqués dans le même lot.

Il est à noter que la matière utilisée pour la fabrication des spiraux est notamment un alliage de base principale Fe/Ni/Cr dans lequel peuvent être ajoutés d'autres composants, qui présente les particularités de ne pas devoir obligatoirement subir notamment de traitement thermique, de présenter un coefficient de dilatation et une réaction au magnétisme faibles ainsi qu'un coefficient thermo-élastique (CTE) proche de zéro.

Un assemblage pour organe régulateur d'un mouvement d'horlogerie se compose notamment d'une première partie appelée balancier qui est un volant d'inertie, d'une deuxième partie appelée spiral, en forme de spirale d'Archimède, pour ramener le balancier dans sa position de repos et d'une troisième partie appelée virole qui permet de fixer le centre du spiral sur l'axe du balancier.

Le balancier se compose d'une masse notamment annulaire et, dans un cas de figure qui n'est pas une construction classique, est relié par des bras au plateau, ce dernier étant une rondelle portant la cheville de plateau, l'ensemble étant ajusté sur l'axe du balancier pour recevoir les impulsions de l'ancre et les transmettre au dit balancier.

La virole est notamment cylindrique et dispose d'une partie centrale circulaire évidée permettant d'introduire et de fixer l'axe du balancier.

Le spiral est notamment de section parallélépipède et dispose d'une extrémité dont la partie terminale s'écarte de la dernière spire avantageusement avec un angle adouci pour permettre une meilleure distribution de la force dudit spiral et est solidarisée au piton. A l'opposé, le spiral dispose d'une extrémité solidaire de la virole.

Dans un cas de figure, le spiral et la virole sont monobloc et forment un ensemble appelé spiral qui est fixé au balancier par notamment un moyen conventionnel, tel qu'un piton, et à travers un porte-piton.

Relevons encore que dans des cas de figure différents :
- la section du spiral est en forme de U, T, L constante ou variable afin d'optimiser le dit spiral et pour permettre une répartition des tensions homogènes entre l'intérieur et l'extérieur dudit spiral,
- le spiral dispose d'un pas constant ou variable, pour les mêmes raisons que précédemment,
- le spiral est bidirectionnel et dispose d'une partie externe de ses spires qui s'ouvrent lorsque l'autre partie interne se ferme ceci pour obtenir une compensation de l'élongation.

Il est à noter que les spiraux obtenus présentent de faibles perturbations dues aux points d'intersection des spiraux sur la virole et aux effets Grossmann et Caspari.

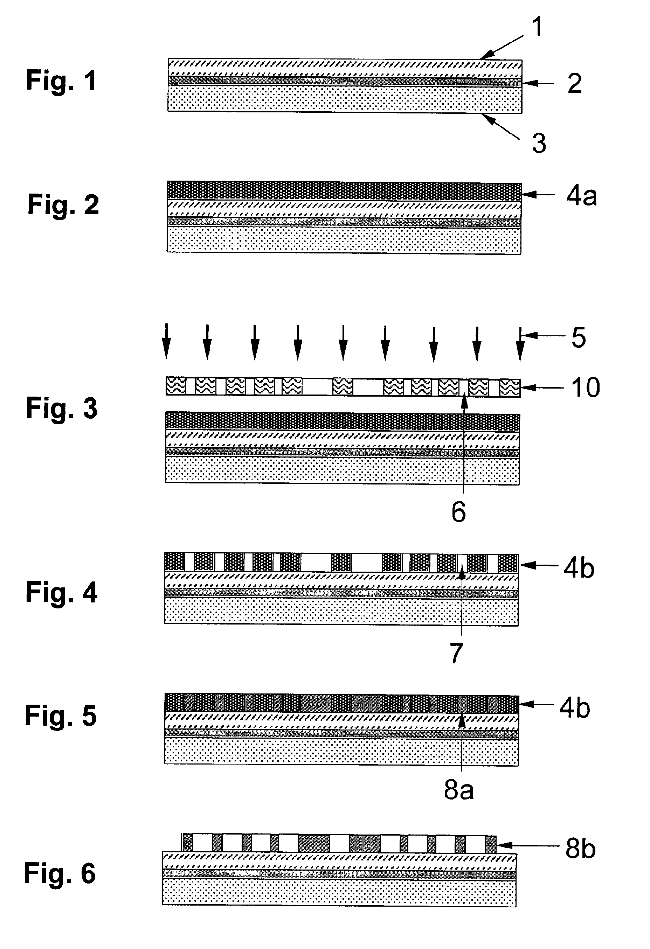

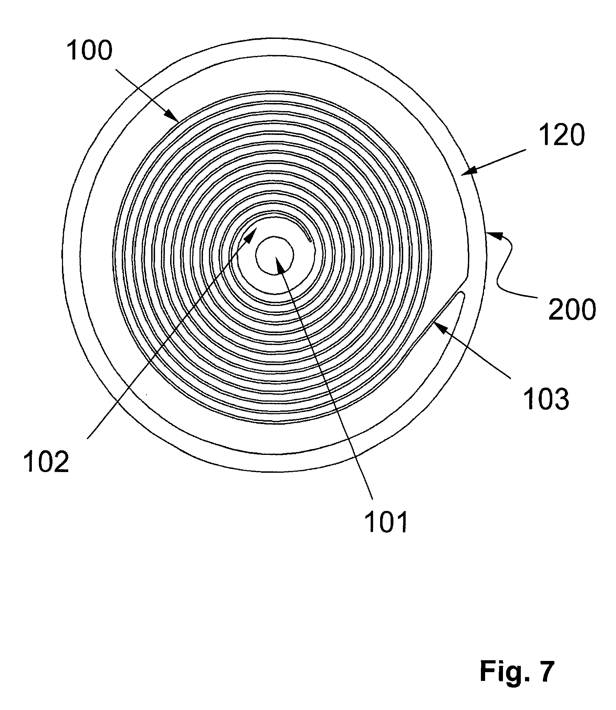

L'invention sera mieux comprise grâce à la description détaillée qui va suivre en se référant, à titre d'exemple, aux dessins annexés concernant le procédé de fabrication (figures 1 à 6) et les assemblages pour organe régulateur d'un mouvement d'horlogerie (figures 7 à 13) obtenus par ce procédé dans lesquels :
- La figure 1 représente en coupe la première étape de préparation des couches nécessaires en vue de débuter une opération de photostructuration/électroformage à savoir le dépôt d'adhésion et de la couche supérieure.
- La figure 2 représente en coupe le recouvrement de la préparation par un masque photo résistant ou couche photo sensible.
- La figure 3 représente en coupe l'exposition aux rayons UV de la couche photo sensible à travers un masque.
- La figure 4 représente en coupe la microstructure (moule) après exposition aux rayons UV et le masque retiré.
- La figure 5 représente en coupe la microstructure remplie du métal de fabrication d'un spiral.
- La figure 6 représente en coupe le spiral obtenu après enlèvement de la microstructure ayant servi de moule.
- La figure 7 représente une vue de dessus d'un organe régulateur monobloc d'une montre incluant le balancier, le spiral et la virole.
- La figure 8 représente une vue de dessus d'un spiral et d'une virole monobloc.
- La figure 9 représente une vue de dessus d'un spiral bidirectionnel dont une partie de ses spires s'ouvre lorsque l'autre partie se ferme.
- La figure 10 représente une vue de dessus d'un spiral avec correction du centre de gravité.
- La figure 11 représente une vue de dessus d'un spiral à section variable.
- La figure 12 représente une coupe des sections de spiraux optimisés en forme de T, U et L.
- La figure 13 représente une vue de dessus d'un spiral dont l'angle d'attache de l'extrémité écartée de la dernière spire est adouci.

En se référant à la figure 7, un organe régulateur (200) pour mouvement d'horlogerie se compose d'un balancier (120) qui est une masse notamment annulaire de section rectangulaire et utilisé comme volant d'inertie, d'un enroulement (100) en forme de spirale d'Archimède appelé spiral servant de ressort de rappel au balancier (120) dont il est intégré par un élargissement de l'extrémité dudit spiral (100), et d'une virole (102) notamment cylindrique utilisée pour introduire et fixer l'axe du balancier (120), ce dernier étant introduit dans un évidement (101) de ladite virole (102). Relevons que cette exécution permet la fabrication d'un échappement dont le balancier (120) est relié par des bras à un plateau (non représenté).

Pour obtenir l'organe régulateur (200) notamment monobloc pour mouvement d'horlogerie de la présente invention on applique les étapes du procédé de fabrication suivantes :
1) dépôt d'une couche d'adhésion entre une couche supérieure conductrice (1) en or ou nickel et un substrat (3), formant ainsi les couches préparatoires de la figure 1,
2) recouvrement des couches préparatoires de la figure 1 d'un masque photo sensitif résistant (4a), figure 2,
3) adjonction d'un masque Cr (10) ouvert selon la forme de l'organe régulateur à produire (6), figure 3,
4) exposition aux rayons UV (5), figure 3,
5) enlèvement des parties exposées du masque sensitif photo résistant (4a) et obtention d'un moule (4b) ayant la forme de l'organe régulateur à produire (7), figure 4,
6) remplissage du moule (4b) par électrodéposition à couches épaisses par un alliage Fe/Ni/Cr (8a), figure 5,
7) Enlèvement du moule (4b) et obtention de la pièce (8b), figure 6.

En résumé, les étapes 1 et 2 font partie de la préparation de la procédure, les étapes 3 à 5 incluent un procédé appelé photostructuration et les étapes 6 et 7 incluent l'électroformage.

Il est à noter, tel que précisé au point 6, que la matière de remplissage par électrodéposition à couches épaisses utilisée pour la fabrication de l'organe régulateur (200) est un alliage Fe/Ni/Cr dans lequel peuvent être ajoutés d'autres composants de la composition voulue qui présente les particularités de ne pas obligatoirement devoir subir notamment de traitement thermique, de présenter un coefficient de dilatation et une réaction au magnétisme faibles ainsi qu'un coefficient thermo-élastique (CTE) proche de zéro.

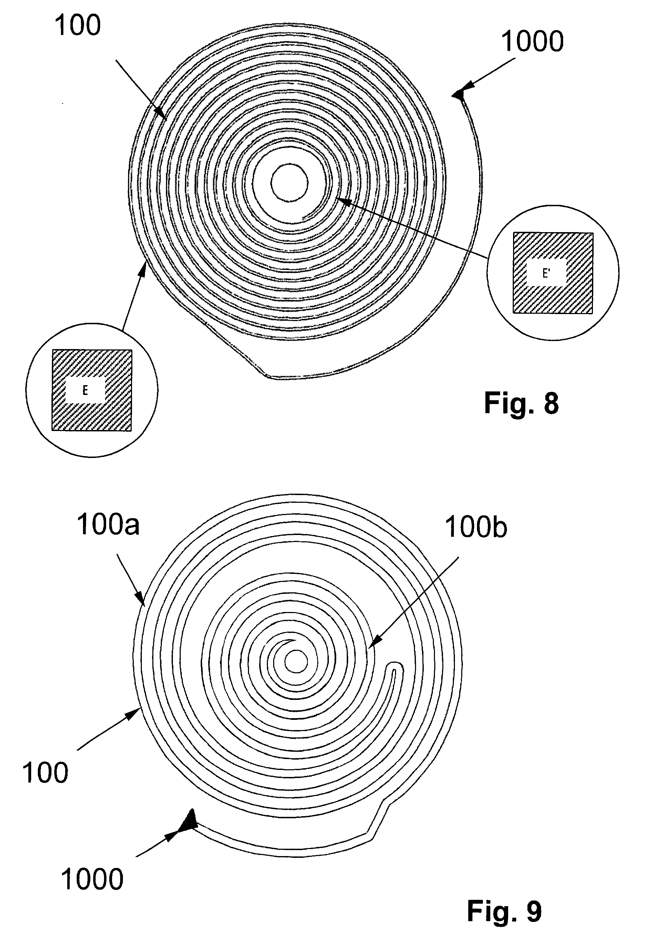

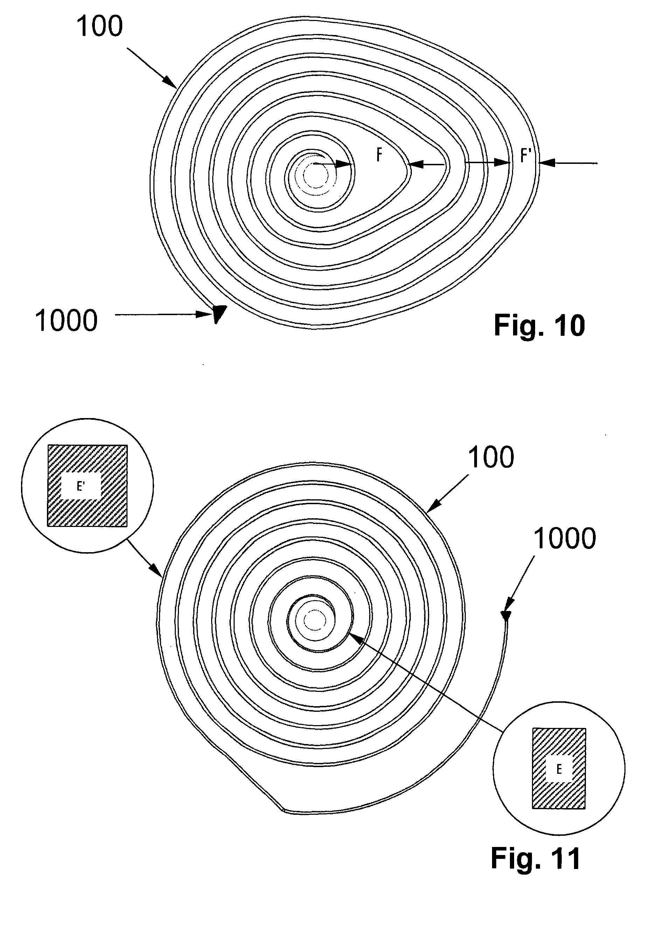

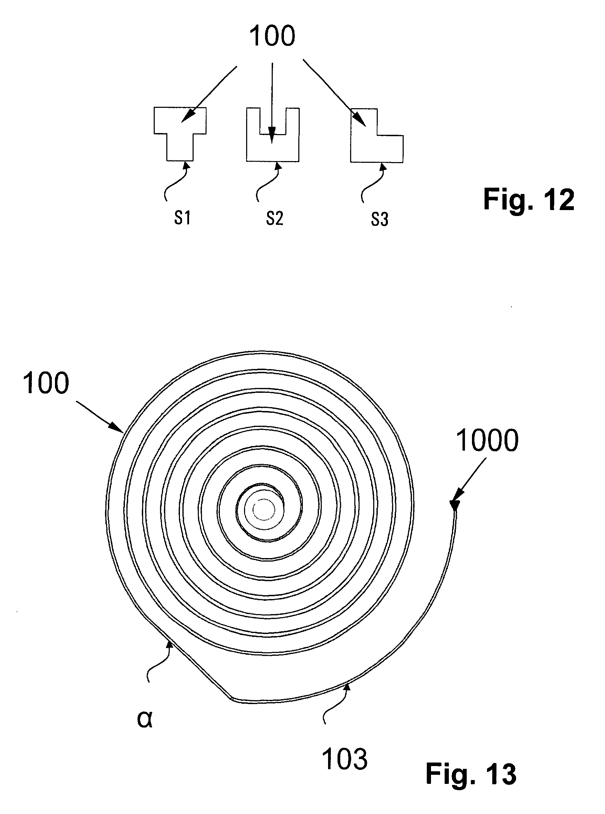

A partir du modus operandi susmentionné on produit des organes régulateurs (200) notamment monoblocs pour mouvements d'horlogerie en grande quantité à partir d'une seule étape de photostructuration et permet d'obtenir les organes régulateurs (200), de formes optimales calculées selon des modèles mathématiques compliqués ou autres. Par ailleurs, selon le même procédé, on produit les assemblages pour organes régulateurs suivants :
- Tel qu'illustré à la figure 7, on produit un spiral (100) en une seule pièce incluant le balancier (120) attaché par un renforcement.
- Tel qu'illustré à la figure 8, on produit un spiral (100) qui est notamment de section (E) parallélépipède constante.
- Tel qu'illustré à la figure 9, on produit un spiral (100) qui dispose d'un enroulement de ses spires en deux parties, l'une externe enroulée antihoraire (100a) et l'autre interne enroulée horaire (100b), si bien que lors des oscillations du balancier (120) les spires (100a) s'ouvrent alors que les spires (100b) se ferment et vice et versa ceci pour compenser l'élongation.
- Tel qu'illustré à la figure 10, on produit un spiral (100) qui dispose d'un pas (F, F') variable (F ≠ F') d'un côté le long de l'axe des flèches F-F' ceci pour obtenir une oscillation constante.
- Tel qu'illustré à la figure 11, on produit un spiral (100) qui est notamment de section (E, E') parallélépipède variable (E ≠ E') de hauteur constante, en l'occurrence une section E rectangulaire vers le centre évoluant jusqu'à une section E' carrée à l'extérieur.
- Tel qu'illustré à la figure 12, on produit un spiral (100) qui dispose d'une section notamment en forme de U, T ou L (S1, S2, S3) constante afin d'optimiser le dit spiral (100).
- En variante de l'exécution de la figure 12, on produit un spiral (100) qui dispose de la section notamment en forme de U, T ou L (S1, S2, S3) variable pour permettre une répartition des tensions homogènes entre l'intérieur et l'extérieur dudit spiral (100).
- Tel qu'illustré à la figure 13, on produit un spiral (100) qui dispose d'une partie terminale (103) qui s'écarte de la dernière spire avec un angle (α) ou une forme adouci pour permettre une meilleure distribution de la force dudit spiral (100).
- Tel qu'illustré aux figures 8, 9, 10, 11 et 13, l'extrémité externe du spiral (100) est élargie et a la forme d'un cône (1000) ou alternativement d'une boucle.

Il est à noter que les spiraux (100) obtenus présentent avantageusement de faibles perturbations dues aux points d'attache des spiraux (100) sur la virole (102) et aux effets Grossmann et Caspari.

## Revendications

1. Assemblage pour organe régulateur (200) d'un mouvement d'horlogerie comprenant un spiral (100) et une virole (102) **caractérisé en ce que** le spiral (100) et la virole (102) sont fabriqués en une seule pièce, obtenable par photostructuration et électroformage.

2. Assemblage pour organe régulateur (200) selon la revendication 1, **caractérisé en ce que** le spiral (100) est notamment de section (E) parallélépipède constante

3. Assemblage pour organe régulateur (200) selon la revendication 1, **caractérisé en ce que** le spiral (100) est notamment de section (E) parallélépipède variable.

4. Assemblage pour organe régulateur (200) selon la revendication 1, **caractérisé en ce que** le spiral (100) dispose d'une section (E) en forme de U, T ou L (S1, S2, S3) constante.

5. Assemblage pour organe régulateur (200) selon la revendication 1, **caractérisé en ce que** le spiral (100) dispose d'une section (E) en forme de U, T ou L (S1, S2, S3) variable.

6. Assemblage pour organe régulateur (200) selon la revendication 1, **caractérisé en ce que** le spiral (100) dispose d'un pas (F) constant.

7. Assemblage pour organe régulateur (200) selon la revendication 1, **caractérisé en ce que** le spiral (100) dispose d'un pas (F) variable.

8. Assemblage pour organe régulateur (200) selon la revendication 1, **caractérisé en ce que** le spiral (100) dispose d'une extrémité (103) dont la partie terminale s'écarte de la dernière spire sans pliage ultérieur.

9. Assemblage pour organe régulateur (200) selon la revendication 1, **caractérisé en ce que** l'extrémité du spiral (100) a une forme élargie comme par exemple un cône ou une boucle.

10. Assemblage pour organe régulateur (200) selon la revendication 1, **caractérisé en ce que** le spiral (100) et un balancier (120) sont fabriqués en une seule pièce.

11. Assemblage pour organe régulateur (200) selon la revendication 1, **caractérisé en ce que** le spiral (100) dispose d'un enroulement de ses spires en au moins deux parties, l'une externe enroulée dans un sens par exemple antihoraire (100a) et l'autre interne enroulée dans un autre sens par exemple horaire (100b).

12. Organe régulateur pour mouvement d'horlogerie **caractérisé en ce qu'**il comporte un balancier (120), un spiral (100) et une virole (102) fabriqués en une seule pièce, obtenable par photostructuration et électroformage.

13. Mouvement de montre comprenant un assemblage pour organe régulateur (200) selon l'une quelconque des revendications 1 à 11 ou un organe régulateur (200) selon la revendication 12.

14. Procédé de fabrication d'un assemblage pour organe régulateur selon l'une quelconque des revendications 1 à 11, **caractérisée en ce que** le spiral (100), la virole (102) et éventuellement le balancier (120) sont fabriqués en une seule pièce par photostructuration et électroformage.

15. Procédé de fabrication selon la revendication 13, **caractérisé en ce qu'**il comporte les étapes suivantes :
- dépôt d'une couche d'adhésion (2) entre une couche supérieure conductrice (1) et un substrat (3),
- recouvrement de la dite couche supérieure par un masque photo sensitif résistant (4a),
- adjonction d'un masque (10) ouvert selon la forme (6) de l'organe régulateur à fabriquer,
- exposition aux rayons UV (5),
- enlèvement du masque sensitif photo résistant (4a) et obtention d'un moule (4b) ayant la forme de l'organe régulateur à fabriquer,
- remplissage du moule (4b) par électrodéposition par un alliage à base de Fe/Ni/Cr (8a) dans lequel peuvent être ajoutés d'autres composants,
- enlèvement du moule (4b) et obtention de l'organe régulateur (8b).
